# EUROPEAN PATENT APPLICATION

(11) **EP 1 975 720 A1**
(43) Date of publication of application: **01.10.2008**
(21) Application number: 06834142.9
(22) Date of filing: 06.12.2006
(51) Int. Cl.: G03F 7/20, H01L 21/027, H01S 3/134

(54) **LASER LIGHT SOURCE DEVICE, EXPOSURE METHOD, AND DEVICE**

(30) Priority: 09.12.2005 JP 2005357015
(71) Applicant: NIKON CORPORATION, Tokyo 100-8331 (JP)
(72) Inventor: TOKI, Tsuyoshi NIKON CORPORATION INT. PROP. DEP., Chiyoda-ku, Tokyo 100-8331 (JP)
(74) Representative: HOFFMANN EITLE
(86) International application number: PCT/JP2006/324387
(87) International publication number: WO 2007/066700

(57) **Abstract**

Information on the side of the body of an exposure apparatus is effectively used on the side of the laser light source apparatus. There is provided a laser light source apparatus (16) which supplies a laser beam (LB) to an body (20) of an exposure apparatus (EX) which exposes a wafer, and includes a controller (12) adjusting an operation condition of the laser light source apparatus (16) based on exposure information (EI) about the exposure operation supplied from the body (20) of the exposure apparatus. The exposure information (EI) is exemplified by information on the waiting time until the light emission start or light emission continuation time and the operation condition is exemplified by the gas pressure in an emission chamber (1) in which a laser beam is emitted, the temperature in the emission chamber and a number of revolutions of a blower (4) in the emission chamber.

## Description

### TECHNICAL FIELD

The present invention relates to a control technique for controlling a laser light source apparatus and an exposure technique for exposing an object by using a laser beam. The present invention is preferably applicable, for example, when a laser light source apparatus is used as an exposure light source for an exposure apparatus used to transfer a mask pattern onto a substrate in the lithography step in order to produce various devices including, for example, semiconductor devices, image pickup devices (CCD, etc.), and liquid crystal displays.

### BACKGROUND ART

In the lithography step as one of the steps of producing a semiconductor device, for example, a wafer as a substrate (or a glass plate or the like) on which a resist is coated, is exposed with a pattern which is formed on a reticle as a mask. In this procedure, an exposure apparatus of the full field exposure type such as a stepper or of the scanning exposure type such as a scanning stepper is used. In such an exposure apparatus, the exposure wavelength is gradually shortened in order to enhance the resolution. Recently, an excimer laser light source is mainly used as the exposure light source, which performs the spectrum narrow-banded pulse oscillation and which is of the electric discharge excitation type, as exemplified, for example, by the KrF excimer laser (wavelength: 248 nm) and the ArF excimer laser (wavelength: 193 nm). The laser beam, which is pulse-oscillated from the laser light source, is subjected to uniformizing process for the beam intensity (illuminance) in an illumination optical system of a body of the exposure apparatus (exposure-apparatus body), and the laser beam is radiated onto the reticle.

Conventionally, the following procedure is adopted. That is, the pulse energy and the light emission frequency, which are to be set upon the light emission, are set before the start of the exposure in the exposure-apparatus body. After that, a trigger signal, which gives notice of the light emission timing for every pulse, is transmitted from the exposure-apparatus body to the laser light source. The pulse light emission is performed in the laser light source in synchronization with the trigger signal (see, for example, Japanese Patent Application Laid-open No. 2001-148344). In other words, until the trigger signal is transmitted, those disposed on the side of the laser light source do not have any information about when the next laser beam is to be emitted. On the other hand, for example, if any error which disables the continuance of the exposure arises on the side of the exposure-apparatus body, then in the conventional technique, those disposed on the side of the laser light source are on standby while waiting for the arrival of the instruction (trigger signal) of the light emission from the exposure-apparatus body in such a state that there is no information at all.

Further, in the conventional technique, the parameters including the spectrum width, the center wavelength of the laser beam, etc. are monitored only on the side of the laser light source; and any information about the change of the parameter is not especially utilized on the side of the exposure-apparatus body.

### DISCLOSURE OF THE INVENTION

### Task to Be Solved by the Invention:

The pattern of the semiconductor device is increasingly made fine and minute. In the exposure apparatus to be used when the semiconductor device is produced, it is necessary to improve the control accuracy for the exposure amount in order to reduce the error of CD (Critical Dimension) as the line width of the transferred fine pattern image. For this purpose, it is necessary to improve the stability of the output, i.e., the stability of the energy of the laser beam by enhancing the control accuracy for the energy of every pulse of the laser beam on the side of the laser light source as well.

However, in the case of a control method in which the laser light source performs the light emission only based on the trigger signal transmitted from the exposure-apparatus body as in the conventional technique, it has been difficult to perform the pulse light emission in such a state that any control accuracy to be required is maintained. Further, even when an error, due to which the exposure has to be temporarily discontinued, arises in the exposure-apparatus body, the conventional laser light source merely waits for the trigger signal to be supplied from the exposure-apparatus body. Therefore, if the waiting state is prolonged, it has been difficult to maintain such a situation that any control accuracy to be required is obtained. As a result, when the error is dissolved and the exposure is restarted, then it is feared that the stability of the energy of the laser beam might be lowered. Further, it is necessary to enhance the stability of the output of an illumination light beam to be emitted or generated as well when the exposure light source is not the pulse light source but is a light source which emits or generates a continuous light beam.

In the conventional technique, the parameters including the spectrum width, the center wavelength of the laser beam etc. are not used on the side of the exposure-apparatus body. However, for example, in order to improve the yield, it is desirable that the parameters are also used by the exposure-apparatus body.
Taking the foregoing viewpoints into consideration, the present invention has been made in order that, when the laser light source is used as an exposure light source or the like, the information about those on the side of a body of an exposure apparatus or the like is utilized more effectively on the side of a laser light source, and the information about those disposed on the side of the laser light source is utilized more effectively on the side of the main body of the exposure apparatus or the like.
More specifically, a first object of the present invention is to provide a laser light source apparatus which makes it possible to improve the control accuracy or the stability of the output by using the information about those disposed on the side of a main body of an exposure apparatus or the like, and an exposure technique using the laser light source apparatus.
Further, a second object of the present invention is to provide an exposure technique which makes it possible to utilize the information representing the state of a laser beam when a laser light source is used as an exposure light source.

### Solution for the Task:

According to the present invention, there is provided a laser light source apparatus which supplies a laser beam to a body (20) of an exposure apparatus exposing an object, the laser light source apparatus comprising a controller (12) which adjusts an operation condition of the laser light source apparatus based on information about an exposure operation supplied from the body of the exposure apparatus.
According to the present invention as defined above, it is possible to improve the stability of the output or the control accuracy of the output by using the information about the exposure operation on the side of the laser light source apparatus to make the preparation for the start of the light emission (exposure) to be performed next time.

In the present invention, an example of the information about the exposure operation is information about at least one of a light emission continuance time and a waiting time until start of light emission. An example of the operation condition includes at least one of conditions of a gas pressure in a chamber in which the laser beam is emitted, a temperature in the chamber, and a number of revolutions of a blower in the chamber. Another example of the information about the exposure operation includes error information about the body of the exposure apparatus or error information about an apparatus (50) connected to the body of the exposure apparatus.

According to another aspect of the present invention, there is provided a first method for controlling a laser light source apparatus which supplies a laser beam to a processing apparatus (20), the first method comprising: obtaining information about a time regarding an operation of the processing apparatus; and adjusting an operation condition of the laser light source apparatus based on the information about the time.
According to still another aspect of the present invention, there is provided a second method for controlling a laser light source apparatus which supplies a pulsed light beam to a processing apparatus (20), the second method comprising: emitting the pulsed light beam based on a light emission trigger signal supplied from the processing apparatus; and changing, before the light emission trigger signal is supplied, an operation condition of the laser light source apparatus in a waiting state in which the pulsed light beam is not emitted.
According to the control methods of the present invention as defined above, it is possible to control the laser light source apparatus by using the information concerning those disposed on the side of the processing apparatus.
According to still another aspect of the present invention, there is provided an exposure method for forming a predetermined pattern on a substrate by using a laser beam from a laser light source apparatus, the exposure method comprising using, for the laser light source apparatus, the laser light source apparatus of the present invention, or applying the method for controlling the laser light source apparatus of the present invention. According to the present invention, the control accuracy or the stability of the output of the laser beam is improved. Therefore, it is possible to improve the CD (Critical Dimension) error, etc.

According to still another aspect of the present invention, there is provided an exposure apparatus having a laser light source (16) which emits a laser beam and a body (20) of the exposure apparatus which exposes an object with the laser beam, the exposure apparatus comprising: a monitor device (9, 10) which monitors a state of the laser beam emitted from the laser light source; and a storage device (35) which stores information about the state of the laser beam monitored by the monitor device such that the information is associated with a result of exposure performed by the body of the exposure apparatus. According to the present invention, the information about the state of the laser beam is stored such that the information is associated with the exposure result, thereby making it possible to utilize the information about the state of the laser beam for analysis of the factor of the exposure result, etc.
In order that the present invention is understood more easily, the explanation has been made as corresponding to the drawings which illustrate an embodiment. However, it goes without saying that the present invention is not limited to the embodiment. The construction of the embodiment corresponding to the drawings may be appropriately improved, and at least a part or parts of the construction may be substituted with any other constitutive component or components.

### BRIEF DESCRIPTION OF THE DRAWINGS

Fig. 1 shows an exposure system according to a first embodiment.
Fig. 2 shows an exposure apparatus according to a second embodiment.
Fig. 3 shows another example of a laser light source apparatus according to the embodiment.
Fig. 4 shows an exemple of a measuring system for measuring the degree of polarization.

### Legend of reference numerals:

1: electric discharge chamber, 4: blower, 6: laser resonator, 9: monitor section, 10: spectrum calculating section, 11: storage-correction calculating section, 12: controller, 13: reference light source, 16, 16A, 16B: laser light source apparatus, 20: body of exposure apparatus (exposure-apparatus body).

### BEST MODE FOR CARRYING OUT THE INVENTION

### First Embodiment

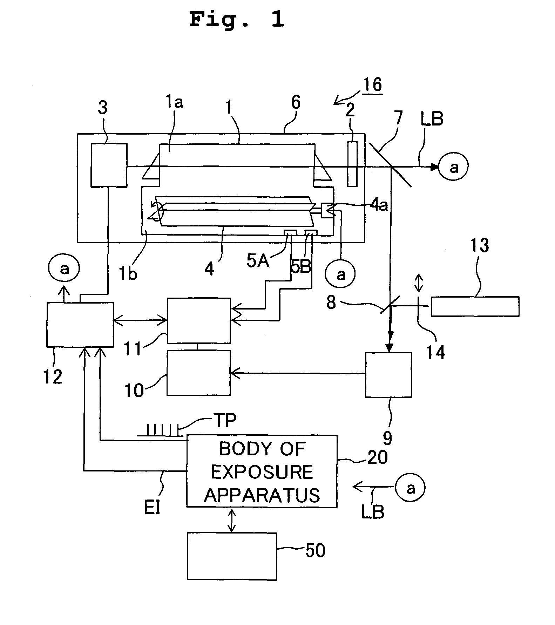

A first preferred embodiment of the present invention will be explained below with reference to Fig. 1. In this embodiment, the present invention is applied to a laser light source apparatus which performs the pulse oscillation.
Fig. 1 shows a block diagram illustrating an exposure system including the laser light source apparatus 16 of this embodiment. With reference to Fig. 1, the laser light source apparatus 16 includes a laser resonator 6; a beam splitter 7 which is arranged on the optical path for a laser beam LB (laser radiation) radiated from the laser resonator 6 and which has a transmittance of about 97 %; a half mirror (or a beam splitter) 8 and a monitor section 9 which are successively arranged on the reflection optical path of the beam splitter 7; a reference light source 13; a spectrum calculating section 10 into which a detection signal is inputted from the monitor section 9; a storage-correction calculating section 11 to which spectrum information from the spectrum calculating section 10 and detection information of a plurality of sensors (which will be described later on) are supplied; and a controller 12 which controls the light emission operation of the laser light source apparatus 16. The controller 12 includes a light emission controller including a computer controlling the light emission operation as well as a laser power source section, and the like. The storage-correction calculating section 11 stores a target value including gas pressure described later on and spectrum characteristic, etc. supplied from the controller 12. Further, the storage-correction calculating section 11 determines information about an error between the target value and an actually measured value, and supplies the information to the controller 12. The light emission controller in the controller 12 performs the feedback control for the laser power source section, etc. in order to decrease the error (details will be described later on).

The laser resonator 6 is accommodated in a predetermined housing. The laser resonator 6 includes an electric discharge chamber (excimer laser tube) 1 which includes an electric discharge electrode constructed of the ArF excimer laser (oscillation wavelength: 193 nm) or the KrF excimer laser (oscillation wavelength: 248 nm), a total reflection rear mirror 3 which is arranged on the back side of or behind the electric discharge chamber 1, a front mirror 2 which is arranged on the front side of or in front of the electric discharge chamber 1 and which has a low reflectance (high transmittance), and a narrowbanding module (not shown) which is arranged between the electric discharge chamber 1 and the front mirror 2. In this case, a resonator is constructed by the rear mirror 3 and the front mirror 2.

The unillustrated narrowbanding module is constructed, for example, by including a fixed Fabry-Perot etalon (hereinafter abbreviated as "etalon") and a tunable tilt etalon which are successively arranged on the optical path for the laser beam LB. The etalon has two silica glass plates which are opposite to or facing each other in parallel with a predetermined gap (air gap), and functions as a kind of bandpass filter. The fixed etalon is provided for the coarse tuning, and the tunable tilt etalon is provided for the fine tuning. These etalons output the laser beam LB while narrowing the spectrum width of the laser beam LB radiated from the laser resonator 6, for example, to a degree of about 1/100 to 1/300 of the natural oscillation spectrum width. Further, the controller 12 adjusts the tilt angle of the tunable tilt etalon via an unillustrated driving mechanism, to thereby make it possible to shift the wavelength (center wavelength) of the laser beam LB, radiated from the laser resonator 6, within a predetermined range. The narrowbanding module can be also constructed by combining, for example, a prism and a diffraction grating. The narrowbanding module can be also arranged at a position of the total reflection mirror arranged behind the electric discharge chamber 1.

The electric discharge chamber 1 is filled with a laser gas of a predetermined mixing ratio (composed of krypton Kr (or argon Ar) as a medium gas, fluorine F₂, and helium He as a buffer gas). Therefore, one end of a flexible gas supply tube is connected to the electric discharge chamber 1 via an unillustrated gas feed valve; and the other end of the gas supply tube is connected to gas cylinders (not shown) of Kr (Ar), F₂, He, etc. For example, a flexible gas discharge tube is connected to the electric discharge chamber 1 via an unillustrated gas discharge valve. The gas discharge tube is provided with a removing filter for trapping fluorine, a gas discharge pump, etc, for the purpose of discharging the waste gas to the outside of the apparatus by the gas discharge pump after making the waste gas to be harmless by the removing filter. Each of the valves is controlled to be opened and closed by the controller 12.

The electric discharge chamber 1 is comparted into an electric discharge portion 1a in which the electric discharge is performed, and a gas-circulating portion 1b from which the gas is supplied to the electric discharge portion 1a. A blower 4, which is constructed of a rotary member (fan) provided with a plurality of slender blades or impellers, etc. in order to satisfactorily mix a plurality of types of internal gases and to efficiently supply the gases to the electric discharge portion 1a, is installed in the gas-circulating portion 1b. Upon oscillating the laser, the controller 12 controls the number of revolutions (rpm) of the blower 4 via a driving motor 4a so that the laser gas is always circulated at the predetermined mixing ratio in the electric discharge chamber 1.

Those installed in the electric discharge chamber 1 are a pressure sensor 5A which detects the internal gas pressure, a temperature sensor 5B which detects the internal gas temperature, and a partial pressure sensor (not shown) which detects the pressures of the plurality of types of internal gases (or which detects the mixing ratio of the gases) individually. Results of the detection performed by the sensors are supplied at a predetermined sampling rate to the storage-correction calculating section 11. For example, upon exchanging the gas, the controller 12 makes the adjustment so that the laser gas in the electric discharge chamber 1 has the predetermined mixing ratio and pressure; and upon oscillating the laser, the controller 12 controls the gas temperature in the electric discharge chamber 1 via an unillustrated heater.

A shutter (not shown), which opens and closes the optical path for the laser beam LB, is arranged between the front mirror 2 and the beam splitter 7. A shutter 14, which opens and closes the optical path for the light beam supplied from the reference light source 13, is provided on the optical path between the reference light source 13 and the half mirror 8. When the controller 12 controls the opening/closing of the shutters, any one of the laser beam LB and the light beam from the reference light source 13 can be made to selectively come into the monitor section 9.

The monitor section 9 includes therein an energy monitor and a beam monitor (spectrum monitor). A light-receiving element such as a PIN type photodiode having a high response frequency, is used as the energy monitor. A photoelectric conversion signal (light amount signal) from the energy monitor is supplied to the storage-correction calculating section 11 to calculate any error from the target value. On the other hand, a Fabry-Perot interferometer including for example an etalon, a telemeter lens, a licensor, etc. is used as the beam monitor. When the laser beam branched from the laser beam LB comes into the etalon, the diffracted light beam on the partial reflecting surface of the etalon repeats reflection and transmission in the air gap. In this situation, only light beams having predetermined angles of incidence are transmitted through the etalon and mutually strengthened, thereby forming the interference fringes (fringe pattern) on the focal surface of the telemeter lens; and the fringe pattern is detected by the licensor, and the result of detection is supplied to the spectrum calculating section 10. The distribution of the light intensities detected by the licensor includes the information about a peak-shaped spectrum of the laser beam LB corresponding to the interference fringes at predetermined intervals in relation to the longitudinal direction of the licensor on the focal surface.

The spectrum calculating section 10 of this embodiment determines the spectrum width and the center wavelength of the laser beam (or the light beam of the reference light source 13) coming into the monitor section 9 by using, for example, the result of detection by the beam monitor. The centroid wavelength (mean wavelength or momentum center) of the spectrum may be determined in place of the center wavelength. The full width half maximum (FWHM), which is the width of the wavelength with an intensity of 1/2 of the peak, is used as the spectrum width. Alternatively, it is also possible to use the 95 % energy purity width, which is the width obtained when the integral value of the intensity distribution of the spectrum between two wavelengths is 95 % with respect to the total integral value of the intensity distribution of the spectrum. The measured values of the center wavelength and the spectrum width are supplied to the storage-correction calculating section 11, and in the storage-correction calculating section 11, any error from the target value is determined. The error is supplied to the controller 12. The controller 12 adjusts the unillustrated narrowbanding module described above so that the error is corrected.

Upon determining the true value of the center wavelength (hereinafter the true value is referred to as "absolute value" for sake of convenience), namely upon performing an absolute wavelength calibration, for example, the reference light source 13 constructed of a solid narrowbanding laser is used. In this embodiment, an Ar frequency-doubled laser light source (argon ion frequency-doubled high harmonic wave laser light source) is used as the reference light source 13. The center wavelength of the Ar frequency-doubled laser light source is 248.253 nm which is extremely close to the center wavelength λ₀ = 248.385 nm of the KrF excimer laser, and is preferred as the reference of the KrF excimer laser. In the case of the ArF excimer laser, it is appropriate to use, as the reference light source 13, any laser light source having a center wavelength close to the corresponding center wavelength of the ArF excimer laser.

An explanation will now be briefly made about the absolute wavelength calibration by the monitor section 9 and the spectrum calculating section 10. In this procedure, at first, only the shutter 14 is closed. Only the laser beam branched from the laser beam LB is received by the monitor section 9 to obtain the information about the fringe pattern corresponding to the laser beam. The information is stored in the image memory in the spectrum calculating section 10. Subsequently, the shutter on the side of the laser light source apparatus 16 is closed, and the shutter 14 is opened so as to make the light beam coming from the reference light source 13 come into the monitor section 9. The fringe pattern obtained in this situation is compared with the fringe pattern stored in the image memory to determine the deviation of the wavelength of the laser beam LB from the reference wavelength to thereby determine the offset for the measured value of the laser beam LB having been previously obtained with respect to the absolute wavelength. The offset is stored in the storage section in the storage-correction calculating section 11. The operation to determine the offset is the absolute wavelength calibration. After that, in the storage-correction calculating section 11, the offset is added to the measured value of the wavelength of the laser beam LB supplied from the spectrum calculating section 10, thereby making it possible to calculate the wavelength of the laser beam LB highly accurately. The absolute wavelength calibration may be performed periodically or regularly, for example, before the start of the exposure.

Subsequently, the laser beam LB radiated from the laser light source apparatus 16 and transmitted through the beam splitter 7 illuminates, as the exposure light beam, the reticle as the mask via an illumination optical system in a body 20 of the exposure-apparatus (exposure-apparatus body 20). The exposure-apparatus body 20 includes the illumination optical system; a reticle stage which is movable while holding the reticle; a projection optical system which projects an image of a pattern of the reticle onto the wafer coated with a resist as the substrate (object); a wafer stage which is movable while holding the wafer; a main control system and an exposure amount control system which collectively control the exposure operation; and the like. A coater/developer 50 is connected to the exposure-apparatus body 20 in order that the wafer is coated with the resist, that the wafer is supplied to the exposure-apparatus body 20, and that the resist of the exposed wafer is developed.

A trigger signal TP is transmitted from the exposure amount control system in the exposure-apparatus body 20 of this embodiment to the controller 12 of the laser light source apparatus 16 via a predetermined signal line in order to instruct a series of pulse light emission timings during the exposure; and an exposure information EI, which includes the information about the exposure operation, is supplied from the main control system in the exposure-apparatus body 20 to the controller 12 via the same signal line or another signal line. Further, the exposure amount control system supplies an information about the exposure target pulse energy to the controller 12 of the laser light source apparatus 16, for example, before the exposure of the leading wafer of the lot to be processed.

For example, the following information about (a1) and (a2) is supplied as the exposure information EI from the exposure-apparatus body 20 to the controller 12 before the start of the exposure.
(a1): number of shots scheduled to be exposed in the wafer (exposure continuance time (light emission continuance time) for one sheet of the wafer is determined by multiplying (a1) by the exposure time per one shot); and
(a2): waiting time of the laser light source apparatus 16 until the start of the next exposure (start of the light emission). At least one of (a1) and (a2) may be actually supplied.
The waiting time of the laser light source apparatus 16 of (a2) includes exposure rest or pause time scheduled between the wafers (during the period in which the exposed wafer is exchanged with the next wafer), etc.; predicted waiting time from the stop of the light emission to the start of the light emission of the laser light source apparatus 16 due to any error of the exposure-apparatus body 20, etc.; and predicted waiting time indicating a likely duration of the remaining waiting time.

The controller 12, receiving the exposure information EI from the exposure-apparatus body 20, optimally adjusts the following operation conditions (b1) to (b5) of the laser light source apparatus 16 depending on the exposure information EI.
(b1): gas pressure in the electric discharge chamber 1, (b2): gas partial pressure in the electric discharge chamber 1, (b3): gas temperature in the electric discharge chamber 1, (b4): number of revolutions of the blower 4 in the electric discharge chamber 1, and (b5): application voltage to be applied to the electrode in the electric discharge chamber 1 during the oscillation.

In reality, for example, as for the gas pressure of (b2), an open loop control may also be allowable, which is based on the control of flow rates of the respective gasses to be fed from the plurality of cylinders as described above, instead of the feedback control based on the measured value of the partial pressure sensor. As for the application voltage in the electric discharge chamber of (b5), the control may be made after the trigger signal TP has arrived from the exposure-apparatus body 20, because the response speed is extremely fast. Other than above, as for the gas pressure of (b1), the gas temperature of (b3), and the number of revolutions of the blower 4 of (b4) each as the operation condition in which the response speed is slow during the control, it is allowable that only at least one of the (b1), (b3) and (b4) is controlled.

Specifically, for example, when the information about the waiting time until the start of the next light emission is supplied, then the gas temperature of (b3) is lowered beforehand during the initial part of the waiting time, and the gas temperature is raised beforehand to the temperature to be used during the oscillation approximately when the waiting time comes to an end (for example, immediately before the arrival of the trigger signal TP). By doing so, it is possible to prolong the service life of the electric discharge chamber 1, and it is possible to stably perform the pulse light emission with the instructed energy immediately after the start of the light emission. When the oscillation frequency is raised, the number of revolutions of the blower 4 of (b4) is previously raised gradually, thereby making it possible to enhance the stability of the output energy and the spectrum characteristic.

Parameters, which can be stabilized in relation to the laser beam LB outputted from the laser light source apparatus 16 by adjusting the operation conditions of (b1) to (b5) described above, are the following main parameters (c1) to (c6).
(c1): output energy (pulse energy). This parameter can be controlled to some extent by the application voltage in the electric discharge chamber 1 of (b5) as well as by the gas pressure in the electric discharge chamber 1 of (b1) and the gas temperature in the electric discharge chamber 1 of (b3). The stability of the output energy, which is brought about when the oscillation frequency is raised, also depends on the number of revolutions of the blower 4 in the electric discharge chamber 1 of (b4).

(c2): spectrum width. This parameter can be controlled to some extent by the gas partial pressure (concentration ratio) in the electric discharge chamber 1 of (b2).
(c3): center wavelength. This parameter (c3) and the following parameters (c4) to (c6) can be also controlled to some extent by the unillustrated narrowbanding module described above. However, these parameters also depend on the stability of the operation conditions of (b1) to (b5) described above.

(c4): light intensity distribution in the profile of the spectrum of the laser beam LB;
(c5): degree of polarization; and
(c6): spatial coherence.
As described above, according to the laser light source apparatus 16 of this embodiment and the method for controlling the laser light source apparatus 16 (executed by the controller 12), the operation conditions of the laser light source apparatus 16 are previously adjusted based on the exposure information EI supplied from the exposure-apparatus body 20 to the controller 12 of the laser light source apparatus 16, other than the trigger signal TP. By doing so, it is possible to stabilize the parameters including the output energy of the laser beam LB immediately after the start of the light emission. Therefore, it is possible to reduce the CD error as the error of the line width of the pattern image to be transferred on the side of the exposure-apparatus body 20, and it is possible to highly accurately produce an electronic device having a fine pattern.

As described below, in this embodiment, the exposure information EI also includes an error information indicating that the exposure cannot be continued, for example, because the autofocus is not operated satisfactorily in the exposure-apparatus body 20, and an error information indicating the exposure cannot be continued because the process is stopped in the coater/developer 50, etc.
That is, when the error arises in the exposure-apparatus body 20 or the coater/developer 50, etc. connected to the exposure-apparatus body 20, and the exposure is temporarily stopped, then the information (error information) indicating that the exposure is stopped due to the occurrence of the error is transmitted as the exposure information EI, for example, from the main control system of the exposure-apparatus body 20 to the controller 12 of the laser light source apparatus 16. The controller 12 waits while allowing the laser light source apparatus 16 to be in the standby state in response to the error information. Then, after an information about the recovery of the error is transmitted from the exposure-apparatus body 20 to the controller 12, the controller 12 restores the laser light source apparatus 16 to be in a state that the laser light source apparatus 16 is capable of performing the oscillation. With this, it is possible to stabilize the output energy during the oscillation while prolonging the service life of the electric discharge chamber 1.

When the error arises in the exposure-apparatus body 20 or the coater/developer 50, etc. connected to the exposure-apparatus body 20 as described above, and the exposure is temporarily stopped, then it is allowable that, as another exemple, the contents of the error may be classified into the following (d1) to (d5) in the main control system of the exposure-apparatus body 20 to inform or notify the controller 12 of the laser light source apparatus 16.
(d1): temporal error (expected to be recovered within several seconds), (d2): error expected to be recovered within several minutes, (d3): error to wait assistance by an operator, (d4): serious error having no probability of immediate recovery, and (d5): error of unidentifiable or unknown cause.

The controller 12 of the laser light source apparatus 16, receiving the error information in the classified form as described above, selects the optimum waiting mode of the laser light source apparatus 16 depending on the contents of the error. For example, against the temporal error of (d1), the gas temperature in the electric discharge chamber 1 may be lowered a little, and the number of revolutions of the blower 4 may be also lowered a little beforehand; and against the error (d4) having no probability of immediate recovery, the standby state may be provided. By selecting the waiting mode on the side of the laser light source apparatus 16 depending on the classification of the error as described above, it is possible to avoid any unnecessary consumption of energy, and it is possible to obtain the high energy stability upon the start of the oscillation thereafter.
The information, relating to the oscillation frequency of the laser beam LB to be used for the exposure and the pulse energy amount of the laser beam LB, is also supplied before the exposure as the exposure information EI to the controller 12 of the laser light source apparatus 16. The pulse energy amount is detected by an unillustrated sensor (integrate sensor) provided for the illumination optical system in the exposure-apparatus body 20.

### Second Embodiment

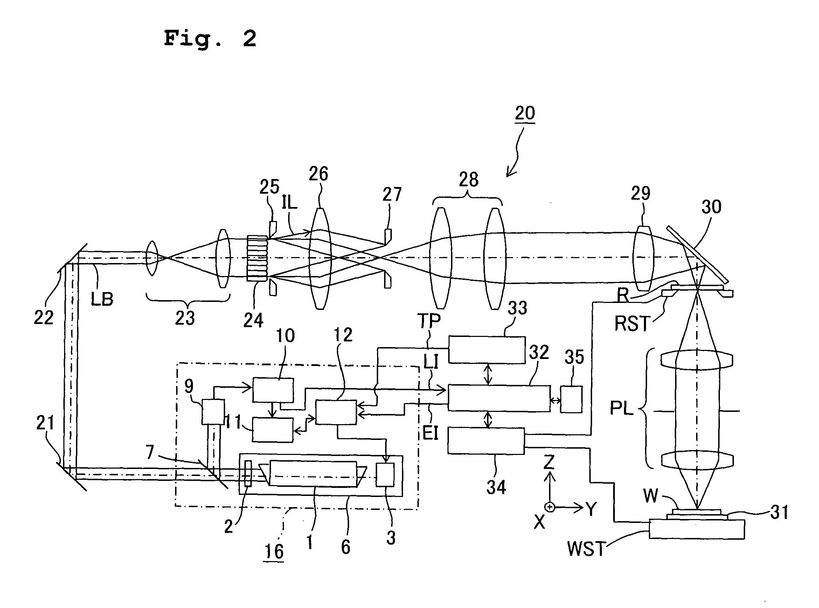

Next, a second embodiment of the present invention will be explained with reference to Fig. 2. In Fig. 2, the components or parts, which correspond to those shown in Fig. 1, are designated by the same reference numerals, any detailed explanation of which will be omitted.
Fig. 2 shows an exposure apparatus of the scanning exposure type constructed of a scanning stepper including a laser light source apparatus 16 and an exposure-apparatus body 20 of this embodiment. The laser light source apparatus 16 shown in Fig. 2 is constructed in the same manner as the laser light source apparatus 16 shown in Fig. 1 (for the purpose of simplification, the reference light source 13 and the sensors 5A, 5B shown in Fig. 1 are omitted from the illustration). With reference to Fig. 2, the laser beam LB, radiated from the laser light source apparatus 16 as the exposure light source, comes into the illumination optical system of the exposure-apparatus body 20, via mirrors 21, 22.

In the illumination optical system, the laser beam LB comes into a fly's eye lens 24 as an optical integrator (uniformizer or a homogenizer), via a beam-shaping system 23. A diffraction optical element, etc. may be used instead of the fly's eye lens 24. An aperture diaphragm plate 25 is arranged on the light exit surface of the fly's eye lens 24, i.e., on the pupil plane of the illumination optical system, in order to set the illumination condition to the ordinary illumination, the zonal or annular illumination, the multipolar illumination, etc.

The laser beam LB exiting from the fly's eye lens 24 and passing through a predetermined aperture diaphragm in the aperture diaphragm plate 25, comes into an illumination system blind 27 as the exposure light beam IL (exposure beam), via a lens system 26. The illumination system blind 27 is provided with a fixed blind (fixed illumination field diaphragm) and a movable blind (movable illumination field diaphragm). The latter movable blind is arranged on the conjugate plane conjugate with the pattern surface (reticle surface) of the reticle R, and the former fixed blind is arranged on a plane which is defocused by a predetermined amount from the conjugate plane. The exposure light beam IL passing through the illumination system blind 27, illuminates a slit-shaped illumination area on the pattern surface of the reticle R as the mask, via a first condenser lens system 28, a second condenser lens system 29, and an optical path-bending mirror 30. The illumination optical system is constructed to include the members from the beam-shaping system 23 to the mirror 30.

An image of a circuit pattern in the illumination area of the reticle R is transferred, at a predetermined projection magnification β (β is, for example, 1/4, 1/5 or the like) via the projection optical system PL, by being irradiated with the exposure light beam IL to the slit-shaped exposure area of a resist layer on one of shot areas, on the wafer W as the substrate (object), arranged on the focusing plane of the projection optical system PL. The following description will be made assuming that a Z axis extends in parallel to the optical axis of the projection optical system PL, an Y axis extends in the scanning direction (direction parallel to the sheet surface of Fig. 2 in this embodiment) in a plane perpendicular to the Z axis, and an X axis extends in the non-scanning direction (direction perpendicular to the sheet surface of Fig. 2 in this embodiment) perpendicular to the scanning direction.

With reference to Fig. 2, the reticle R is attracted and held on a holding surface on a reticle stage RST. The reticle stage RST is placed on a reticle base (not shown) so that the reticle stage RST is movable at a constant velocity in the Y direction and the reticle stage RST is finely movable in the X direction, the Y direction, and the direction of rotation. The two-dimensional position of the reticle stage RST (reticle R) is measured in real-time by an unillustrated laser interferometer. The main control system 32 controls the operation of the reticle stage RST based on an obtained result of the measurement, via the stage control system 34.

On the other hand, the wafer W is attracted and held on a wafer stage WST via a wafer holder 31. The wafer stage WST is two-dimensionally movable on a wafer base (not shown) along the XY plane which is parallel to the image plane of the projection optical system PL. The positions of the wafer stage WST in the X direction and the Y direction and the angles of rotation about the X axis, the Y axis, and the Z axis are measured in real-time by an unillustrated laser interferometer. A main control system 32 controls the operation of the wafer stage WST based on an obtained result of the measurement, via the stage control system 34. Further, an alignment sensor (not shown) is also provided which performs the alignment for the reticle R and the wafer W. Further, an exposure amount control system 33, which is controlled by the main control system 32, supplies a result of the detection performed by an integrate sensor (not shown) monitoring the light amount of the exposure light beam IL to the controller 12 of the laser light source apparatus 16 so that the optimum illuminance is obtained on the wafer W based on the result of the detection performed by the above-described sensor (integrate sensor); and the exposure amount control system 33 transmits, independently of the detection result, the timing of the light emission with the trigger signal TP. The main control system 32 supplies the exposure information EI described above to the controller 12.

In the ordinary exposure, the operation in which the exposure light beam IL (laser beam LB) is radiated onto the reticle R and the reticle R and the wafer W are synchronously moved with respect to the projection optical system PL via the reticle stage RST and the wafer stage WST at a velocity ratio equivalent to the projection magnification, and the operation in which the radiation of the exposure light beam IL is stopped and the wafer stage WST is driven to step-move the wafer W are repeated in the step-and-scan manner. In accordance with the operations as described above, the image of the pattern of the reticle R is transferred to and exposed onto all of the shot areas on the wafer W.

Upon transferring the image of the pattern of the reticle R to each of the shot areas of the wafer W as described above, the exposure result is affected by the state of the spectrum width, the center wavelength of the laser beam LB, etc. in some cases. Accordingly, in order to manage the exposure result (including the analysis of factors), all or at least a part of the information LI indicating the state of the laser beam of (e1) to (e7) as described below is transmitted during the exposure of every shot of the wafer to the main control system 32 of the exposure-apparatus body 20 from the spectrum calculating section 10 (monitor device) of the laser light source apparatus 16 of this embodiment. The transmitted information is stored as a part of the information (log) of the exposure result of every shot in the storage device 35 connected to the main control system 32 (analyzing device).

(e1): average spectrum width of the laser beam LB in the shot, (e2): maximum value and minimum value of the spectrum width in the shot, (e3): average value of the center wavelength of the laser beam LB in the shot, (e4): maximum value and minimum value of the center wavelength in the shot, (e5): maximum value and minimum value of the centroid position of the profile of the spectrum in the shot, (e6): maximum value and minimum value of the degree of polarization of the laser beam LB in the shot, and (e7): average energy of the laser beam LB in the shot.

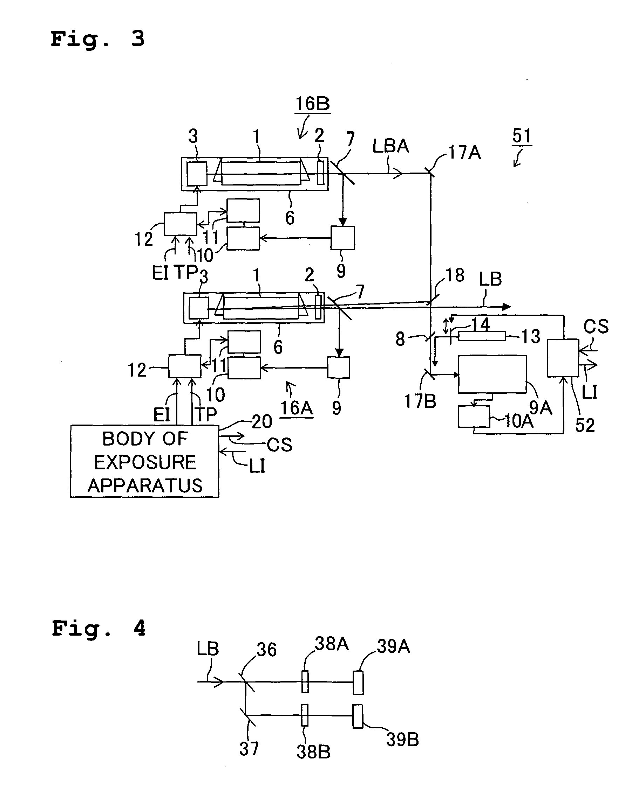

In order to measure the degree of polarization of the laser beam LB, for example, the following procedure is available as shown in Fig. 4. That is, it is allowable that the laser beam LB is divided into two light fluxes by a half mirror 36 and a mirror 37; and the two light fluxes are received by photoelectric sensors 39A, 39B, respectively, via polarizing plates 38A, 38B having directions of polarization perpendicular to each other. The degree of polarization can be calculated from the outputs of the photoelectric sensors 39A, 39B.
With reference to Fig. 2 again, for example, the main control system 32 analyzes the relationship, for example, between the state of the laser beam LB concerning (e1) to (e7) described above and the CD error for each of the shot areas of the wafer W developed after the completion of the exposure and/or the result of judgment to determine whether or not the final product is approvable or not. By doing so, the main control system 32 determines an allowable range of the state of the laser beam LB concerning (e1) to (e7). Upon performing subsequent exposure thereafter, for example, the following procedure is adopted. That is, upon exposing a wafer at the leading head of 1 lot, if the information LI (values of (a1) to (a7) described above), indicating the state of the laser beam transmitted from the laser light source apparatus 16 to the main control system 32, is not within the allowable range, then the main control system 32 instructs those disposed on the side of the laser light source apparatus 16 to adjust the state of the laser beam, thereby making it possible to optimize the state of the laser beam.

A laser light source apparatus 51 shown in Fig. 3 is also usable instead of the laser light source apparatus 16 described above. In Fig. 3, the components or parts, which correspond to those shown in Fig. 1 are designated by the same or similar reference numerals, wherein two laser light source apparatuses 16A, 16B, which are constructed in an approximately same manner as the laser light source apparatus 16 shown in Fig. 1, are arranged in parallel. However, in this embodiment, the reference light source, which emits the reference light beam for the laser beam coming into the monitor section 9, is not provided in the laser light source apparatuses 16A, 16B. Further, any narrowbanding module is not installed between the front mirror 2 and the electric discharge chamber 1 of the first laser light source apparatus 16A. However, a narrowbanding module (not shown) is installed between the front mirror 2 and the electric discharge chamber 1 of the second laser light source apparatus 16B. Further, the narrowbanding module can be also arranged at the position of the rear mirror 3. A laser beam LBA, in which the center wavelength and the spectrum width are controlled highly accurately although of which output is small, is emitted in pulses in the second laser light source apparatus 16B. The laser beam LB, in which the output of the laser beam LBA is amplified, is emitted in pulses in the first laser light source apparatus 16A. The laser beam LB is used as the exposure light beam in the exposure-apparatus body 20.

That is, with reference to Fig. 3, the laser beam LBA, radiated from the laser light source apparatus 16B, is reflected by a mirror 17A and a beam splitter 18, and the laser beam LBA is allowed to come into the laser resonator 6 of the laser light source apparatus 16A. The laser beam LB, which is amplified by the laser resonator 6, is radiated from the laser light source apparatus 16A.

The laser beam LBA, transmitted through the beam splitter 18, is allowed to come into a monitor section 9A constructed in the same manner as the monitor section 9, via a half mirror 8 and a mirror 17B. The reference light source 13 is arranged in the vicinity of the monitor section 9A. In this construction, the reference light beam from the reference light source 13 can be switched with the laser beam LBA by closing a shutter (not shown) disposed on the side of the laser light source apparatus 16B and opening the shutter 14, thereby allowing the reference light beam to come into the monitor section 9A via the half mirror 8. The detection signal supplied from the monitor section 9A is processed by a spectrum calculating section 10A constructed in the same manner as the spectrum calculating section 10, thereby making it possible to determine the absolute value of the wavelength of the laser beam LBA, and consequently the laser beam LB as well, based on the wavelength of the reference light beam. The information LI, which indicates the state of the laser beam including the information about the absolute value of the wavelength obtained by the spectrum calculating section 10A, is transmitted from an interface section 52 to the exposure-apparatus body 20 in response to a data request command CS from the exposure-apparatus body 20.

The laser light source apparatuses 16A, 16B of this embodiment are operated in the same manner as in the first embodiment so that the operation condition of the laser resonator 6 is adjusted based on the exposure information EI from the exposure-apparatus body 20 and the pulse light emission is performed based on the trigger signal TP. However, the absolute wavelength calibration is not performed for the laser beam in each of the laser light source apparatuses 16A, 16B. Upon performing the absolute wavelength calibration, the data request command CS is transmitted from the exposure-apparatus body 20 to the interface section 52, and the information about the absolute value of the wavelength of the laser beam LB detected by the monitor section 9A and the spectrum calculating section 10A is transmitted to the exposure-apparatus body 20 in response to the data request command CS. The information about the absolute value of the wavelength of the laser beam LB is supplied also as a part of the exposure information EI to the controller 12 of the laser light source apparatus 16B. The controller 12 determines, as the offset, the error of the measured value of the wavelength of the laser beam LBA as obtained therebefore with respect to the absolute value of the wavelength; and thereafter corrects the measured value of the wavelength of the laser beam LBA determined by the spectrum calculating section 10 with the offset, thereby making it possible to control the wavelength of the laser beam LBA, and consequently the laser beam LB as well, highly accurately with respect to the target value. Further, the information, which relates to the oscillation frequency of the laser beam LB to be used for the exposure, the pulse energy, the center wavelength, the spectrum width, the degree of polarization, etc. is also supplied, before the exposure, as the exposure information EI to the controller 12 of the laser light source apparatus 16.

Also in this embodiment, the output energy upon the pulse oscillation can be always stabilized by using the exposure information EI previously supplied.
When a semiconductor device is produced by using the exposure apparatus of the embodiment described above, the semiconductor device is produced by performing a step of designing the function and the performance of the device; a step of manufacturing a reticle based on the designing step; a step of forming a wafer from a silicon material; a step of performing the alignment by the exposure apparatus of the embodiment described above and exposing the wafer with a pattern of the reticle; a step of forming a circuit pattern by the etching, etc.; a step of assembling the device (including a dicing step, a bonding step, and a packaging step); an inspection step; and the like.

It is apparent that the present invention is not limited to only the scanning type exposure apparatus, and the present invention is also applicable in a case that the exposure is performed by any projection exposure apparatus of the full field exposure type (stationary exposure type) such as a stepper. As for the exposure apparatus, the present invention is also applicable to an exposure apparatus of the step-and-stitch system in which at least two patterns are partially overlaid and transferred on the wafer. As for the exposure apparatus, the present invention is also applicable to a proximity exposure apparatus in which the exposure is performed with the pattern of the mask while allowing the mask and the substrate to make close contact with each other without using the projection optical system. The present invention is also applicable in a case that the exposure is performed by using a liquid immersion type exposure apparatus as disclosed, for example, in International Publication No. 99/49504. The present invention is also applicable in a case that the exposure is performed by using a projection exposure apparatus in which the extreme ultraviolet light beam (EUV light beam) having a wavelength of about several nm to 100 nm is used as the exposure light beam (laser beam). In this case, the exposure light beam is not limited only to the pulsed light beam, and may be a continuous light beam.

The present invention is not limited to the application to the exposure apparatus for producing the semiconductor device. The present invention is also widely applicable, for example, to an exposure apparatus for producing a liquid crystal display device to be formed on a rectangular glass plate or a display apparatus such as a plasma display as well as to an exposure apparatus for producing various devices including, for example, an image pickup device (for example, CCD), a micromachine, a thin film magnetic head, MEMS, a DNA chip, etc. Further, the present invention is also applicable to an exposure step (exposure apparatus) to be used upon producing the mask (for example, a photomask and a reticle) formed with the mask pattern of various devices by using the photolithography step.

As for the exposure apparatus, the present invention is also applicable to an exposure apparatus provided with an exposure stage which is movable while holding a processing-objective substrate such as a wafer and a measuring stage which includes various measuring members and/or sensors, as disclosed in Japanese Patent Application Laid-open No. 11-135400 (corresponding to International Publication No. 1999/23692).

The operation procedures, the various shapes of the respective constitutive members, and the combinations thereof are described in the foregoing respective embodiments merely by way of example. Various changes may be made based on the process condition and the design request, etc. within a range without deviating from the gist or essential characteristics of the present invention.

The present invention is also applicable to an exposure apparatus of the twin-stage type provided with a plurality of wafer stages. The structure and the exposure operation of the exposure apparatus of the twin-stage type are disclosed, for example, in Japanese Patent Application Laid-open Nos. 10-163099 and 10-214783 (corresponding to United States Patent Nos. 6,341,007, 6,400,441, 6,549,269, and 6,590,634), Published Japanese Translation of PCT International Publication for Patent Application No. 2000-505958 (corresponding to United States Patent No. 5,969,441), and United States Patent No. 6,208,407. Further, the present invention may be applied to a wafer stage described in Japanese Patent Application No. 2004-168481 (corresponding to International Publication No. 2005/122242) previously filed by the applicant of the present invention.

In the respective embodiments described above, those used are the light-transmissive type mask in which a predetermined light-shielding pattern (or phase pattern or dimming or light-reducing pattern) is formed on a light-transmissive substrate and a light-reflective type mask in which a predetermined reflecting pattern is formed on a light-reflective substrate. However, there is no limitation to this. For example, instead of such masks, a transmissive pattern, a reflective pattern, or a light-emitting pattern is formed based on an electronic data of a pattern to be subjected to the exposure (also referred to as "variable shaped mask" including, for example, DMD (Digital Micro-mirror Device) as a kind of the non-light emission type image display device (spatial light modulator)).

The present invention is also applicable, for example, to such an exposure apparatus that the substrate is exposed with interference fringes formed by the interference of a plurality of light fluxes, as referred to as "two-light flux interference exposure". Such an exposure method and such an exposure apparatus are disclosed, for example, in International Publication No. 01/35168.

The g-ray (436 nm), the i-ray (365 nm), etc. can be used for the light source of the exposure apparatus to which the present invention is applied, without being limited only to the KrF excimer laser (248 nm), the ArF excimer laser (193 nm), the F₂ laser (157 nm), etc. As for the magnification of the projection optical system, there is no limitation only to the reduction system. It is also allowable to adopt any one of the 1x magnification system and the magnifying system.

When a linear motor is used for the wafer stage and/or the reticle stage (see, for example, United States Patent No. 5,623,853 or 5,528,118), it is allowable to use any one of those of the air floating type using the air bearing and those of the magnetic floating type using the Lorentz's force or the reactance force. Each of the stages WST, RST may be either of a type in which the movement is effected along a guide or of a guideless type in which no guide is provided.

As for the driving mechanism for each of the stages, it is also allowable to use a plane motor driving each of the stages by the electromagnetic force, in which the magnet unit including two-dimensionally arranged magnet is opposite to an armature unit including two-dimensionally arranged coil. In this case, any one of the magnet unit and the armature unit may be connected to the stage, and the other of the magnet unit and the armature unit may be provided on the side of a movable surface of the stage.

The reaction force, which is generated in accordance with the movement of the wafer stage, may be mechanically released to the floor (ground) by using a frame member so that the reaction force is not transmitted to the projection optical system, as described in Japanese Patent Application Laid-open No. 8-166475 (corresponding to United States Patent No. 5,528,118).

The reaction force, which is generated in accordance with the movement of the reticle stage, may be mechanically released to the floor (ground) by using a frame member, as described in Japanese Patent Application Laid-open No. 8-330224 (corresponding to United States Patent No. 5,874,820).

The exposure apparatus is produced by assembling the various subsystems including the respective constitutive elements so that the predetermined mechanical accuracy, electric accuracy, and optical accuracy are maintained. In order to secure the various accuracies, those performed before and after the assembling include the adjustment for achieving the optical accuracy for the various optical systems, the adjustment for achieving the mechanical accuracy for the various mechanical systems, and the adjustment for achieving the electric accuracy for the various electric systems. The steps of assembling the various subsystems into the exposure apparatus include the mechanical connection, the wiring connection of the electric circuits, the piping connection of the air pressure circuits, etc. in correlation with the various subsystems. It goes without saying that the steps of assembling the respective individual subsystems are performed before performing the steps of assembling the various subsystems into the exposure apparatus. When the steps of assembling the various subsystems into the exposure apparatus are completed, the overall adjustment is performed to secure the various accuracies as the entire exposure apparatus. It is desirable that the exposure apparatus is produced in a clean room in which the temperature, the cleanness, etc. are managed.

It is a matter of course that the present invention is not limited to the embodiments described above, and may be embodied in various forms within a range, without deviating from the gist or essential characteristics of the present invention. The entire contents of disclosure of Japanese Patent Application No. 2005-357015 filed on December 9, 2005, including the specification, claims, drawings, and abstract, are incorporated herein by reference exactly as they are.

The entire disclosures of all the references mentioned above relating to the exposure apparatus, etc. are incorporated herein by reference within a range of permission of domestic laws and ordinances.

### INDUSTRIAL APPLICABILITY

According to the present invention, when the laser light source is used as the exposure light source, then the information about those disposed the side of the exposure-apparatus body can be utilized more effectively on the side of the laser light source, and the information about those disposed on the side of the laser light source can be utilized more effectively on the side of the exposure-apparatus body. As a result, according to the exposure method of the present invention, a device having a fine pattern can be produced highly accurately owing to the reduction of the CD (Critical Dimension) error, etc. because the stability of the output of the laser beam or the control accuracy is improved.

## Claims

1. A laser light source apparatus which supplies a laser beam to a body of an exposure apparatus exposing an object, the laser light source apparatus comprising a controller which adjusts an operation condition of the laser light source apparatus based on information about an exposure operation supplied from the body of the exposure apparatus.

2. The laser light source apparatus according to claim 1, wherein the information about the exposure operation includes information about at least one of a light emission continuance time and a waiting time until start of light emission of the laser beam.

3. The laser light source apparatus according to claim 1 or 2, wherein the operation condition includes at least one of conditions of a gas pressure in a chamber in which the laser beam is emitted, a temperature in the chamber, and a number of revolutions of a blower in the chamber.

4. The laser light source apparatus according to any one of claims 1 to 3, wherein the information about the exposure operation includes error information about the body of the exposure apparatus or error information about an apparatus connected to the body of the exposure apparatus.

5. The laser light source apparatus according to claim 4, wherein the error information includes a waiting time of the laser light source apparatus brought about by the error and at least one of error information classified depending on a time until recovery of the body of the exposure apparatus.

6. The laser light source apparatus according to any one of claims 1 to 5, wherein the laser beam is a pulsed light beam, and the controller performs control so that the laser beam is emitted in pulses in synchronization with a series of light emission trigger signals supplied from the body of the exposure apparatus independently of the information about the exposure operation.

7. A method for controlling a laser light source apparatus which supplies a laser beam to a processing apparatus, the method comprising:
obtaining information about a time regarding an operation of the processing apparatus; and
adjusting an operation condition of the laser light source apparatus based on the information about the time.

8. The method for controlling the laser light source apparatus according to claim 7, wherein the information about the time regarding the operation of the processing apparatus includes information about at least one of a light emission continuance time and a waiting time until start of light emission of the laser beam.

9. The method for controlling the laser light source apparatus according to claim 7 or 8, wherein the operation condition includes at least one of conditions of a gas pressure in a chamber in which the laser beam is emitted, a temperature in the chamber, and a number of revolutions of a blower in the chamber.

10. The method for controlling the laser light source apparatus according to claim 9, wherein the operation condition is adjusted such that the number of revolutions of the blower in the chamber is adjusted based on the waiting time until the start of the light emission of the laser beam, and the number of revolutions is increased during the waiting time.

11. The method for controlling the laser light source apparatus according to any one of claims 7 to 10, wherein the information about the time regarding the operation of the processing apparatus includes information about a waiting time brought about by an error of the processing apparatus or an apparatus connected to the processing apparatus.

12. The method for controlling the laser light source apparatus according to claim 11, wherein the information about the error includes error information classified depending on a predicted time until recovery of the error.

13. An exposure method for forming a predetermined pattern on a substrate by using a laser beam from a laser light source apparatus, the exposure method comprising using, for the laser light source apparatus, the method for controlling the laser light source apparatus as defined in any one of claims 7 to 12.

14. The exposure method according to claim 13, wherein information about the operation of the processing apparatus is classified in accordance with a predetermined criterion, and the classified information is transmitted from the processing apparatus to the laser light source apparatus to adjust the operation condition depending on the classified information.

15. An exposure apparatus having a laser light source which emits a laser beam and a body of the exposure apparatus which exposes an object with the laser beam, the exposure apparatus comprising:
a monitor device which monitors a state of the laser beam emitted from the laser light source; and
a storage device which stores information about the state of the laser beam monitored by the monitor device such that the information is associated with a result of exposure performed by the body of the exposure apparatus.

16. The exposure apparatus according to claim 15, further comprising an analyzing device which analyzes a factor of the result of exposure by using the information about the state of the laser beam stored, in the storage device, associated with the result of exposure.

17. The exposure apparatus according to claim 15 or 16, wherein the state of the laser beam, which is monitored by the monitor device, includes at least one of a spectrum width of the laser beam, a center wavelength, a centroid wavelength of a spectrum of the laser beam, a degree of polarization, and an average energy of the laser beam.

18. A method for controlling a laser light source apparatus which supplies a pulsed light beam to a processing apparatus, the method comprising:
emitting the pulsed light beam based on a light emission trigger signal supplied from the processing apparatus; and
changing, before the light emission trigger signal is supplied, an operation condition of the laser light source apparatus in a waiting state that the pulsed light beam is not emitted.

19. The method for controlling the laser light source apparatus according to claim 18, wherein the operation condition includes at least one of conditions of a gas pressure in a chamber in which the laser beam is emitted, a temperature in the chamber, and a number of revolutions of a blower in the chamber.

20. The method for controlling the laser light source apparatus according to claim 19, wherein at least one of the conditions of the gas pressure in the chamber, the temperature in the chamber, and the number of revolutions of the blower is changed before the light emission trigger signal is supplied.
